# EUROPEAN PATENT SPECIFICATION

(11) **EP 3 928 407 B1**
(45) Date of publication and mention of the grant of the patent: **04.10.2023**
(21) Application number: 20706093.0
(22) Date of filing: 13.02.2020
(51) Int. Cl.: G01R 21/00, H02J 3/18, H02J 3/22, G01R 21/06

(54) **POWER FACTOR DETERMINATION**
LEISTUNGSFAKTORBESTIMMUNG
DÉTERMINATION DE FACTEUR DE PUISSANCE

(30) Priority: 22.02.2019 GB 201902417
(43) Date of publication of application: 29.12.2021
(73) Proprietor: Baker Hughes Energy Technology UK Limited, Bristol BS48 1BS (GB)
(72) Inventor: HILL, Samuel James, Nailsea, England, BS48 1BS (GB)
(74) Representative: Novagraaf Group
(86) International application number: PCT/EP2020/025067
(87) International publication number: WO 2020/169254

(56) References cited:
- EP-A1- 2 822 136
- US-A- 5 399 955
- US-A- 6 147 484
- US-A1- 2013 194 851
- US-A1- 2016 245 051
- US-A1- 2018 163 910
- US-B1- 6 429 643

## Description

The present invention relates to a method and apparatus for indicating characteristics associated with the power factor of an electric power system. In particular, but not exclusively, the present invention relates to the automated control of power factor to within a desired range in response to an indication of characteristics such as phase difference between voltage and current and/or magnitude of power delivered from an Alternating Current (AC) power source via a power line.

US2016/245051A1 discloses impedance measurement behind a subsea transformer and discloses the preamble of claims 1 and 16.

US5399955A discloses a power factor improving arrangement. US2013/194851A1 discloses phase angle detection in an inverter.

Electrical power is a well-known source of energy. There are however significant costs associated with generating and distributing electrical energy and these tend to increase responsive to increases in electrical power demand. As a result, there is a desire for efficiency in terms of electrical power transmission and its use.

Alternating Current (AC) electrical power is associated with a phase relationship between a voltage and current provided by an AC power source via a power line. When current lags a voltage this is most often due to inductive loads connected to the power line. By contrast when a current leads a voltage this is most often associated with capacitive loads connected to the power line. A balance of inductive and capacitive loads results in an in-phase relationship and is thus associated with the delivery of real or resistive power. An out of phase current and voltage results in apparent or reactive power. A well-known measure of the phase relationship between current and voltage is the power factor. A power factor associated with the delivery of electrical power via a power line has a value of unity when a relationship is effectively resistive. The power factor is positive and less than one when inductive loads take precedence. By contrast a power factor is negative and less than one when capacitive loads take precedence.

An example of when a power factor associated with electrical power provided via a power line is of interest is in subsea oil and gas applications. For such subsea oil applications there is a requirement to supply large amounts of electrical power often to under water loads. For example, such loads could be of the electrical equipment like Subsea Electronic Modules (SEMs) and subsea control pods or the like. Such power is typically provided via umbilical cables from an AC power source above sea level. The umbilical cables themselves can contribute to the power factor of an overall electric power system. For example, an AC power source may be provided on a Floating Production Storage and Offloading (FPSO) vessel.

Typically, the power supplied to the subsea loads is delivered through the umbilical in AC form which can result in poor efficiency and a sub unity power factor of the overall power system. In such an AC system the current and voltage oscillate sinusoidally with a defined frequency. Reactive circuit components/loads (such as capacitors and inductors) result in a tendency for the separation of the voltage and current wave forms thus bringing them out of phase, due to the establishment and collapse of electric and/or magnetic fields. As noted above the introduction of capacitors into an AC system tends to induce a leading current while the introduction of inductors tends to induce a lagging current. The power drawn from the supply (the apparent power) thus tends to be greater than the power supplied to the loads to do work (the true power) as the supply must also provide power for the establishment of the electrical or magnetic fields by the reactive elements. In such circumstances the reactive power does not contribute to the work of the loads in the system as the corresponding current returns to the system in a cyclic manner when the electric or magnetic field collapses. In effect this power is wasted and limits a capacity of supply.

This artefact of AC electrical power delivery can result in a need to over-supply power and over-specify equipment to cope with large power draws. This effect can be significant in large electrical installations typical in subsea oil applications. For example, the umbilical cable, due to its thickness and cladding and significant potential length, can be a highly capacitive load and can thus have a large effect on an overall electric power system power factor. Similarly, addition of extra loads (many of which may contain inductive or capacitive elements) during use and as an oil field develops over time can likewise affect the power factor significantly over time relative to an original design brief. Traditionally adding such further loads to established systems requires complex electrical analysis to determine a necessary increase in power.

The present invention is defined in the accompanying claims.

It is an aim of the present invention to at least partly mitigate one or more of the above-mentioned problems.

It is an aim of certain embodiments of the present invention to provide a method and apparatus for indicating at least one characteristic associated with a power factor for an electric power system that includes a power line that delivers electrical power to a location which optionally is a subsea location.

It is an aim of embodiments of the present invention to utilise an indication of one or more characteristics associated with a power factor to provide a corrective change to return a power factor to or close to a unity value.

It is an aim of certain embodiments of the present invention to selectively connect one or more capacitive elements or one or more inductive elements to a power line to control a power factor associated with the power line and connected loads.

It is an aim of certain embodiments of the present invention to provide a sensing circuit that includes first circuitry for providing an output indicative of a phase difference between voltage and current on a power line and further circuitry that provides an output indicative of real power provided by the power line.

It is an aim of certain embodiments of the present invention to provide a solution to power factor problems and which can be utilised with long offsets and high-power delivery.

It is an aim of certain embodiments of the present invention to provide an autotuning methodology for oil field equipment extensions that can be a bespoke module designed and provided at an initial installation phase or which can be a "bolt on" which can subsequently be retrofitted to an already existing electric power system.

It is an aim of certain embodiments of the present invention to provide for real time power factor correction. That is to say to be able to constantly adjust capacitive and/or inductive loads connected to a power line to try to maintain a power factor within a predefined range of values or to within a given range of a set value. For example, to maintain a power factor above 0.90 or above 0.95.

According to a first aspect of the present invention according to independent claim 1, there is provided an apparatus for indicating a characteristic associated with a power factor for a power line, comprising: at least one first feedback element for coupling to a power line that delivers electrical power from an Alternating Current (AC) source to a load and for providing a first feedback voltage that represents a voltage provided by the power line; at least one further feedback element for coupling to the power line for providing a further feedback voltage that represents a current provided by the power line; and at least one impedance element, having an electrical impedance, wherein a first potential difference across the impedance element that is responsive to a potential difference between the first feedback voltage and the further feedback voltage, indicates a characteristic associated with a power factor for the power line.

Aptly the first feedback element comprises at least one inductive element inductively coupled to the power line; and the further feedback element comprises at least one capacitive element connected to the power line.

Aptly the at least one capacitive element comprises a series of capacitors connected at a first end of the series to the power line and at a remaining end of the series to a remaining connection node.

Aptly the apparatus further comprises a trimmer stage responsive to the first potential difference for selectively trimming and providing an output voltage within a desired voltage range.

Aptly the apparatus further comprises a PI filter stage, responsive to the first potential difference, comprising at least a pair of serially connected capacitors and at least a first and further resistor for supressing noise.

Aptly the apparatus further comprises a diode direction stage comprising a first and a further diode.

Aptly the characteristic is a first reference voltage indicative of a phase relationship between a current and a voltage associated with the power line.

Aptly the apparatus further comprises a resistive element connected in a first series arrangement with the impedance element wherein a first end of the first series arrangement is 180° out of phase with a remaining end of the series arrangement.

Aptly the apparatus further comprises a centre point between the resistive element and said impedance element in the series arrangement is connected to a remaining connection node at a remaining end of a series of capacitors connected at a first end thereof to the power line.

Aptly the characteristic is a further reference voltage indicative of a real power delivered via the power line.

Aptly the apparatus further comprises a further resistive element connected in a further series arrangement with said impedance element wherein a first end of the further series arrangement is connected to a remaining connection node at a remaining end of a series of capacitors connected, at a first end of the series of capacitors, to the power line.

According to a second aspect of the present invention according to dependent claim 13, there is provided apparatus for determining a power factor for a power line, comprising: at least one feedback element for coupling to a power line that delivers electrical power from an Alternating Current (AC) source to a load and for providing a first feedback voltage that represents a voltage provided by the power line; at least one further feedback element for coupling to the power line for providing a further feedback voltage that represents a current provided by the power line; at least one impedance element, having an electrical impedance, arranged whereby a first potential difference across the impedance element that is responsive to a potential difference between the first feedback voltage and the further feedback voltage indicates a characteristic associated with a power factor for the power line; a control unit that provides at least one control signal responsive to said a characteristic; and at least one capacitive element and/or at least one inductive element selectively connectable to the power line responsive to the control signal.

Aptly the control unit is a relay-based control system; said at least one capacitive element comprises a plurality of capacitive elements each with a predetermined capacitance and selectively connectable to the power line; and said at least one inductive element comprises a plurality of inductor elements each with a predetermined inductance and selectively connectable to the power line.

Aptly the control unit is a closed loop control system with a selectable set point; the at least one capacitive element is a variable capacitor having a capacitance that is variable and controllable responsive to the control signal; and the at least one inductive element is a variable inductor having an inductance that is variable and controllable responsive to the control signal.

According to a third aspect of the present invention according to independent claim 16, there is provided a method for indicating at least one characteristic associated with a power factor for a power line, comprising the steps of: providing at least one first feedback voltage that represents a voltage provided by a power line that delivers electrical power from an Alternating Current (AC) source to a load; providing at least one further feedback voltage that represents a current provided by the power line; and providing at least one first potential difference across at least one impedance element, that has an electrical impedance, responsive to a potential difference between the first feedback voltage and the further feedback voltage, whereby the first potential difference is indicative of at least one characteristic associated with a power factor for the power line.

Aptly the method further comprises providing at least one first reference voltage indicative of a phase relationship between a current and a voltage associated with the power line; and simultaneously providing a further reference voltage indicative of a real power delivered by the power line.

Aptly the method further comprises providing the first feedback voltage via at least one inductive element inductively coupled to the power line; and providing the further feedback voltage via at least one capacitive element connected to the power line whereby optionally the capacitive element comprises a series of capacitors connected, at a first end of the series, to the power line and at a remaining end of the series to a remining connection node.

Aptly the method further comprises via a diode direction stage, providing a diode stage output voltage signal; via a PI filter stage, providing a filtered output voltage signal by filtering noise on the diode stage output voltage signal; and via a trimmer stage, providing an output voltage within a desired voltage range responsive to the filtered output voltage signal.

Aptly the method further comprises providing a control signal responsive to the first reference voltage and/or the further reference voltage that selectively connects at least one capacitive element and/or at least one inductive element to the power line.

Aptly the method further comprises automatically correcting a power factor for an electric power system that includes a power line to maintain a power factor to within a predetermined range that is optionally between 1.0 and 0.95.

According to a not claimed fourth aspect there is provided a computer program product stored on non-transitory computer readable storage medium comprising computer instructions that, when executed on at least one processor-based device, cause the at least one processor based device to: provide at least one first feedback voltage that represents a voltage provided by a power line that delivers electrical power from an Alternating Current (AC) source to a load: provide at least one further feedback voltage that represents a current provided by the power line; and provide at least one first potential difference across at least one impedance element that has an electrical impedance, responsive to a potential difference between the first feedback voltage and the further feedback voltage, whereby the first potential difference is indicative of at least one characteristic associated with a power factor for the power line.

According to a fifth aspect of the present invention according to dependent claim 12, there is provided a subsea system comprising a top-side facility comprising an Alternating Current (AC) power source; a power line coupled to the AC power source for power supply to a subsea location; at least one subsea device at the subsea location coupled to the power line; and apparatus for indicating a characteristic associated with a power factor for the power line, comprising: at least one first feedback element for coupling to the power line that delivers electrical power from the AC source to a load and for providing a first feedback voltage that represents a voltage provided by the power line; at least one further feedback element for coupling to the power line for providing a further feedback voltage that represents a current provided by the power line; and at least one impedance element, having an electrical impedance, wherein a first potential difference across the impedance element that is responsive to a potential difference between the first feedback voltage and the further feedback voltage, indicates a characteristic associated with a power factor for the power line.

Certain embodiments, not claimed as such, enable power magnitude and a phase difference between voltage and current associated with delivered power to be monitored and optionally controlled.

Certain embodiments, not claimed as such, provide a method and apparatus for accounting for load changes in oil field equipment and to compensate accordingly to help ensure that there is little or no power waste in the electric power system.

Certain embodiments, not claimed as such, monitor a magnitude and a phase difference between voltage and current of power being delivered to oil field equipment.

Certain embodiments, not claimed as such, provide a voltage reference based upon power magnitude and a voltage reference based on phase difference between voltage and current. A human user or alternatively an automated system can switch in or otherwise vary values for capacitive elements from capacitor banks or inductive elements from inductor banks to achieve a power factor of as close to unity (or some other desired level) as possible.

Certain embodiments, not claimed as such, make use of closed loop control to continuously compensate for power delivery by tuning variable capacitors and/or inductors to help try to achieve an in phase supplied voltage and current.

Certain embodiments, not claimed as such, provide a control module which can be a "bolt on". The "bolt on" module can be retrofitted to an electrical installation subsequent to an initial installation phase to accommodate for changes made to that electrical installation and to control a power factor of the electrical installation to within a predetermined range.

Certain embodiments, not claimed as such, can be utilised to help provide power to a subsea oil field without voltage/current lag and reduced drop. As a result, a better power factor control will put less strain on an electrical system when switching loads and power lines on the system and helps ensure a more reliable system.

Certain embodiments, not claimed as such, provide a power factor control module which can be utilised without the need for detailed electrical analysis of oil field equipment. Rather the module may merely be connected to a power line to work and the system will auto compensate a power factor associated with an electrical installation which includes a power line.

Certain embodiments, not claimed as such, provide for more efficient power delivery relative to conventional electric power systems.

Certain embodiments of the present invention according to dependent claim 12, relate to the control of power factor in a subsea environment. Certain embodiments, not claimed as such, are useful for power delivery industries. Certain embodiments, not claimed as such, are useful for 50 Hz and 60 Hz systems as well as RF Antenna transmitter technology in higher frequency bands. Certain embodiments, not claimed as such, provide circuitry that is adaptable for power factor delivery in a wide range of AC power delivery with a range of frequencies.

Certain embodiments, not claimed as such, can reduce copper cross-sectional areas for the manufacturers of umbilicals as there is no need to have any inbuilt redundancy into the power lines provided in such umbilicals. This helps save money.

Certain embodiments, not claimed as such, can be utilised whereby a rig platform will experience less load since the autotune capability provided by certain embodiments of the present invention will tune a power factor to effectively present less load on infrastructure. Certain embodiments , not claimed as such, can be utilised to reduce required physical space for electrical equipment.

Certain embodiments, not claimed as such, can utilise static capacitor banks and inductor banks which can be relatively maintenance free. Alternatively, capacitor and/or inductor elements that have a variable capacitance or inductance can be utilised to help provide optimum control of power factor.

Certain embodiments, not claimed as such, can be utilised to help indicate one or more characteristics associated with a power factor of a power line and associated electrical installation. This can be achieved without using power factored detection chips or packaged electronic solutions or converting line supply to DC through a bridge rectifier. Optionally certain embodiments of the present invention can be positioned near to an AC power source or alternatively further downstream if required.

Certain embodiments not necessarily claimed in the present invention will now be described hereinafter, by way of example only, with reference to the accompanying drawings in which:
Figure 1 illustrates an FPSO and a subsea location;
Figure 2 illustrates the switching in or out of capacitor elements or inductor elements to achieve a desired power factor; and
Figure 3 illustrates an alternative in which automated continuous compensation occurs via constant or repeated tuning of variable capacitors and/or variable inductors to achieve voltage and current being in phase.

In the drawings like reference numerals refer to like parts.

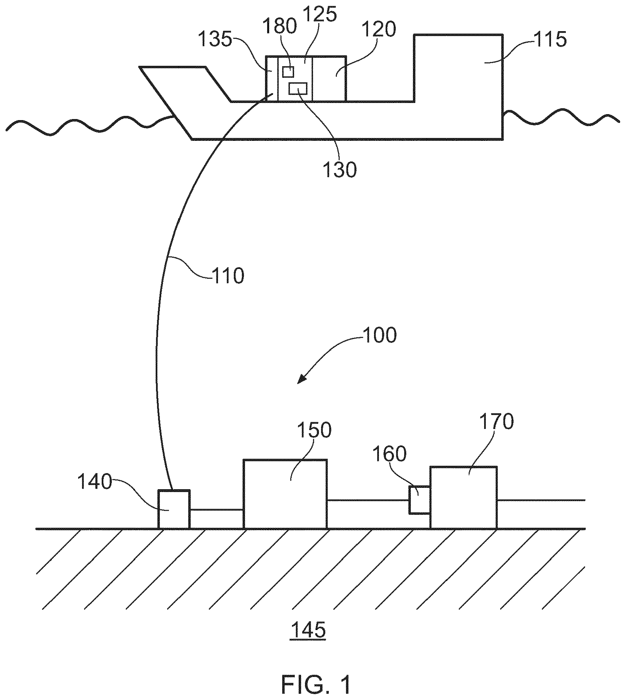

Figure 1 helps illustrate the supply of electrical power to a subsea location 100 via an umbilical 110. As illustrated in Figure 1 a Floating Production Supply and Offloading (FPSO) vessel 115 floats on a sea surface and thus represents a top-side location. The FPSO 115 includes an Electrical Power Unit (EPU) 120 and Master Control Station (MCS) 125. The EPU 120 is an Alternating Current power source and can optionally be included in the MCS 125 internally 130. This is a source of alternating voltage and alternating current. Power is delivered from the MCS to a top-side umbilical distribution unit 135. This is connected to the umbilical 110 which includes a region of a power line (not shown in Figure 1) which runs along the length of the umbilical 110 from the umbilical distribution unit to an Umbilical Termination Assembly (UTA) 140 which is located on the seabed 145. The UTA 140 is connected to a Subsea Distribution Unit (SDU) 150 and this provides power to a subsea control module 160 in a subsea tree 170.

Figure 1 also helps illustrate how a power factor control module 180 can be included in the MSC 125 to help control the power factor associated with the power line in the umbilical and associated load provided by the subsea equipment. It will be appreciated that whilst the power factor control module 180 is shown in the MCS 125 in Figure 1 it will be appreciated that the power factor control module could be located at other points within the overall electrical system. It will likewise be appreciated that whilst Figure 1 relates to an electric power system based on an FPSO and subsea location certain embodiments of the present invention are applicable to other types of electric power system such as land-based systems, fully subsea systems or floating or tethered systems.

Certain embodiments, not claimed as such, allow a power magnitude and/or phase difference between current and voltage for a power line to be monitored and for certain steps to be taken to try to maintain the power factor to within predefined limits. Aptly a magnitude of the power factor is controlled to always be between 1.0 and 0.90. Aptly the power factor is controlled to be between 1.0 and 0.95. According to certain embodiments, not claimed as such, load changes in oil field equipment can be accounted for and compensated for to achieve a required power delivery. This helps reduce power waste in the overall system.

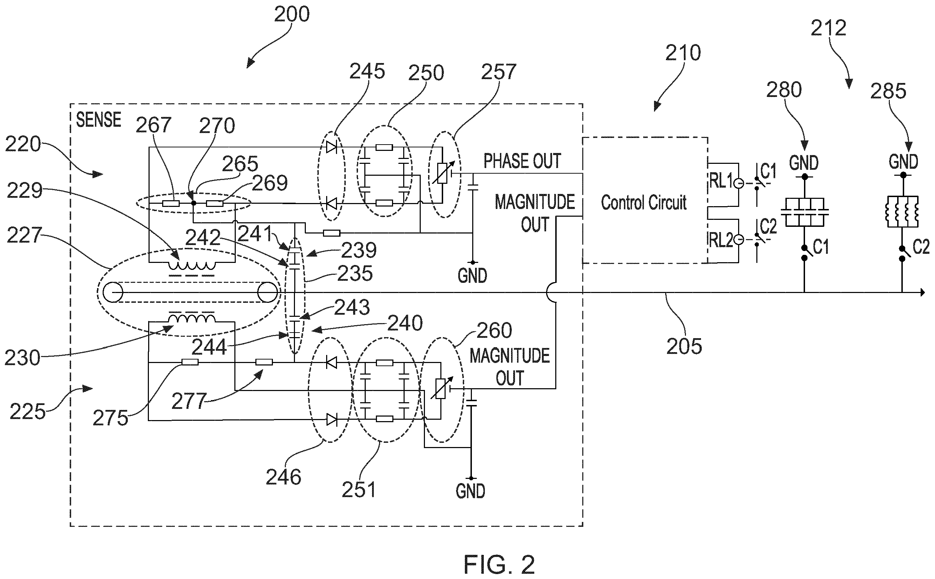

Figure 2 helps to illustrate an embodiment of the present invention for use in subsea oil and gas applications in which Alternating Current (AC) power 110 is provided from a topside power source 130 to subsea loads through an umbilical 110 that includes a power line 205. Aptly the apparatus is placed as close to the supply as possible and contains a sense unit 200, a control unit 210 and a plurality of reactive units 212. The sense unit 200 is coupled to a power line 110 and contains a first sense circuit 220 responsible for providing an indication of a phase difference between a voltage and a current associated with the power line 205 and a further sense circuit 225 responsible for providing an indication of a power magnitude based on the voltage and the current associated with the power line 205. The sense unit 200 includes a first feedback stage 227. The first and the further sense circuitry each includes a part of the feedback stage 227 including components coupled to the power line 205. The sense circuits both contain a first feedback element 229, 230 that is non-intrusively and inductively coupled to the power line 205 for providing a first feedback voltage that is representative of the phase of the voltage associated with the power line 205. Aptly each feedback element 229, 230 comprises a respective inductor.

The first feedback element 229, 230 and the power line 205 can be arranged as a transformer in which the power line 205 acts as a primary coil and the first feedback element such as an inductor 229, 230 acts as a secondary coil. Aptly this is a toroidal transformer but may also be an in-line transformer or any other suitable transformer orientation. It is well known that the voltage induced in a secondary transformer coil is proportional to the rate of change of the magnetic flux through said coil and thus to the rate of change of current through a primary transformer coil. The instantaneous rate of change of current through the primary transformer coil is also proportional to the instantaneous voltage across said coil. Therefore, by inductively coupling the sense circuitry 220 to the power line 205 whereby the power line 205 constitutes a primary transformer coil and the first feedback element 229, 230 constitutes a second transformer coil further constituting a voltage transformer, the voltage signal induced in the first feedback element 229, 230 is representative of the phase of the voltage associated with the power line 205.

The sense unit 200 also includes a further feedback stage 235. The first and further sense circuitry 220, 225 both contain a further feedback element 239, 240 that is intrusively and capacitively coupled to the power line 205 for providing a further feedback voltage representative of the phase of the current associated with the power line 205. In the embodiments shown each further feedback element comprises two capacitors 241, 242, 243, 244 that are connected in pairs, each pair of capacitors connected in series and connected to the power line. The further feedback element allows a flow of AC current via charging and discharging cycles of the series capacitors. The first sense circuit and the second sense circuit 220, 225 both further include a diode direction stage 245, 246, a filter stage 250, 251 and a trimmer stage 257, 260. The diode direction stages 245, 246 each comprise two diodes oriented in such a way as to determine the direction of, and to prevent the backflow of, current through the filter stage 250, 251 and the trimmer stage 257, 260. The filter stage 250, 251 is a PI filter for the attenuation of high frequency noise comprising two serially connected class-Y capacitors, each pair of serially connected capacitors further connected in parallel, and two resistors connected in series with the diode direction stage 245, 246. Other filtering arrangements could of course be utilised. The trimmer stage 257, 260 allows for an output voltage that is representative of a monodirectional and filtered current responsive to the first feedback voltage and the further feedback voltage for indicating a characteristic associated with a power factor of electrical power delivered through the power line at a suitably scaled magnitude for input into the control unit 210.

The first sense circuitry 220 includes a potential divider 265 comprising a first resistor 267 and a further resistor 269 connected in series and arranged across the first feedback element 229. The further feedback element 239 is connected between the first resistor 267 and the further resistor 269 at the centre-tap 270 of the potential divider 265. The apparatus is scaled such that an in-phase voltage and current associated with the power line 205 results in an equal potential difference across the first resistor 267 and the further resistor 269. Aptly a respective end of the potential divider 265 is 180° out of phase with the other end of the potential divider. The potential difference across the first resistor 267 and the further resistor 269 in the potential divider 265 are responsive to the instantaneous value of the first feedback voltage and the instantaneous value of the further feedback voltage provided by the first feedback element 229 and the further feedback element 239 respectively.

If the voltage and current associated with the power line are not in-phase, the instantaneous value of the further feedback voltage varies with respect to the instantaneous value of the first feedback voltage relative to the instantaneous values of the first feedback voltage and the further feedback voltage for an in-phase voltage and current associated with the power line 205. The potential difference across the first resistor 267 and the second resistor 269 within the potential divider 265 then changes accordingly and determines the magnitude and direction of current through the potential divider 265. The direction of current through the remainder of the first sense circuit 220 is determined by the diode direction stage 245 and noise is attenuated at the filter stage 250. The voltage across the trimmer stage 257 is then responsive to the potential difference across the first resistor 267 and the second resistor 269 constituting the potential divider 265. The response of the voltage across the trimmer stage 257 on the first resistor 267 and the second resistor 269 is dictated by the direction of current flow through the potential divider 265 which in turn is dependent on the phase difference between the voltage and current through the power line 205.

As the potential difference across the first resistor 267 and the further resistor 269 varies from a value representative of an in-phase voltage and current associated with the power line 205, the potential difference across the trimmer stage 257 also varies from a value representative of an in-phase voltage and current associated with the power line 205. Aptly the potential difference across the trimmer stage 257 increases or decreases in response to an increase or decrease across the further resistor 269 which is responsive to the phase difference between the voltage and current associated with the power line 205. Aptly the potential difference across the trimmer stage increases or decreases in response to an increase or decrease across the first resistor 267 which is responsive to the phase difference between the voltage and current associated with the power line 205. In this way, an increased or reduced potential difference across the trimmer stage indicates a leading or lagging current associated with the power line wherein the magnitude of this increase or decrease in potential difference across the trimmer stage indicates the magnitude of the phase difference between the voltage and current associated with the power line. The potential difference across the trimmer stage in volts is then representative of the phase difference between the voltage and current associated with the power line in degrees. As the cosine of phase difference in degrees is equivalent to the power factor, the potential difference across the trimmer stage is indicative of the power factor of power delivery through the power line 205. The voltage across the trimmer stage is trimmed to an output voltage suitable for input into the control unit 210. Aptly this is between 0 V and 10 V. Optionally this can be any other suitable voltage. Aptly the capacitors 241, 242 comprising the further feedback element 239 each have a capacitance of between 5 pF and 15 pF. Aptly the capacitors 241, 242 each have a capacitance of 10 pF. Optionally capacitors of any other suitable capacitance can be used. Aptly the resistors 267, 269 constituting the potential divider 265 each have a resistance of between 50 Ω and 150 Ω. Aptly the resistors 267, 269 each have a resistance of 100 Ω. Optionally resistors of any other suitable resistance can be used.

The second sense circuit 225 contains a first resistor 275 connected across the first feedback element 230 of the second sense circuitry and a further resistor 277 connected between the first feedback element and the further feedback element 240. The potential difference across the first resistor 275 is equivalent to the instantaneous value of the first feedback voltage as provided by the first feedback element 230 by Kirchhoff's Voltage Law. The potential difference across the second resistor 277 is responsive to the relative and instantaneous values of the first feedback voltage and the further feedback voltage as provided by the first feedback element 230 and the further feedback element 240 respectively. The potential difference across the further resistor therefore dictates the current through the diode direction stage 246, the filter stage 251 and the trimmer stage 260. The apparatus is scaled such that an in-phase voltage and current associated with the power line 205 yields a maximum amplitude of potential difference between the first feedback voltage and the second feedback voltage and therefore also a maximum amplitude of potential difference across the further resistor 277. This results in a maximum amplitude of current through the diode direction stage 246, the filter stage 251 and the trimmer stage 260. The potential difference across the trimmer stage 260 and the output voltage are therefore also at a maximum amplitude when the voltage and current associated with the power line 205 are in-phase.

If the voltage and current associated with the power line 205 are out of phase, the magnitude of the combined amplitudes of the voltage and current associated with the power line is reduced relative to an in-phase voltage and current associated with the power line 205. This results in a reduced amplitude of potential difference between the first feedback voltage and the further feedback voltage. The amplitude of potential difference across the further resistor 277 is then reduced relative to the amplitude of potential difference across the further resistor 277 for an in-phase voltage and current associated with the power line 205. The amplitude of current through the diode direction stage 246, the filter stage 251 and the trimmer stage 260 is similarly also reduced relative to an in-phase voltage and current associated with the power line 205 which results in a reduced output voltage amplitude. The output voltage is dependent on both the instantaneous magnitude of the voltage associated with the power line and the instantaneous magnitude of the current associated with the power line and is therefore a power magnitude with a maximum value in a system in which the true power and the apparent power are equivalent. The power magnitude or output voltage is therefore representative of the power factor of power delivery through the power line 205. The output voltage is trimmed to a suitable level for input into the control unit 210 at the trimmer stage 260. Aptly this is between 0 V and 10 V. Optionally this can be any other suitable voltage. Aptly the capacitors 243, 244 comprising the further feedback element 240 each have a capacitance of between 5 pF and 15 pF. Aptly the capacitors 243, 244 each have a capacitance of 10 pF. Optionally capacitors of any other suitable capacitance can be used. Aptly the first resistor 275 has a resistance of between 50 Ω and 150 Ω. Aptly the first resistor 275 has a resistance of 100 Ω. Optionally a resistor or any other suitable resistance can be used. Aptly the further resistor 277 has a resistance of between 100 Ω and 500 Ω. Aptly the further resistor 277 has a resistance of 300 Ω. Optionally a resistor of any other suitable resistance can be used.

As highlighted, the output voltages of the first sense circuitry 220 and the second sense circuitry 225 at each trimmer stage 257, 260 are proportionally trimmed to a suitable level for input into the control unit 210. Based upon the output voltage of the first sense circuit 220 and the second sense circuit 225 the control unit 210 switches in capacitor elements in capacitor banks 280 or inductor elements in inductor banks 285 to compensate for reactive loads in the electrical system. The switching in and out of capacitive elements in the capacitor bank 280 or inductive elements in the inductor bank 285 can be automatic or can be controlled by a user based upon a display of characteristics associated with the power factor of power delivery through the power line 205 on a visual display unit such as a computer monitor. The characteristics associated with the power factor of power delivery through a power line 205 may also be displayed or communicated to the user via any other suitable means. Capacitor banks 280 and inductor banks 285 can be automatically switched in or out of the electrical system in an iterative manner to achieve a target or optimal power factor. Alternatively, a required quantity of elements in capacity banks 280 or inductor banks can 285 be automatically switched in or out of the electrical system as calculated by the control unit 210. Alternatively, capacitor banks 280 and inductor banks 285 can be switched in and out of the electrical system manually.

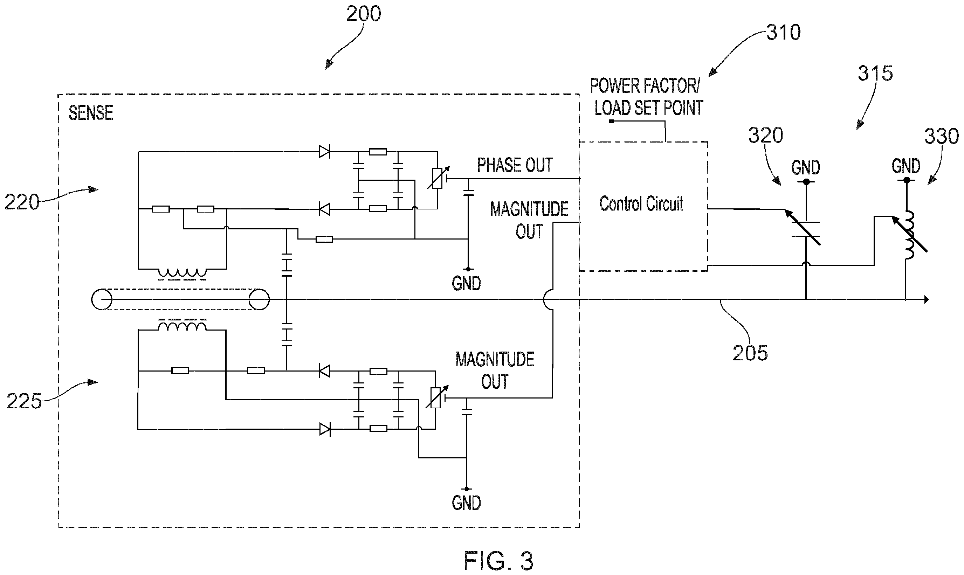

Figure 3 illustrates a further embodiment of the present invention for use in subsea oil and gas applications in which AC power is provided from a topside power supply 130 to subsea loads through an umbilical 110 that includes a power line 205. The composition, arrangement and method of operation of a sense unit 200 is identical to that illustrated in Figure 2. Aptly the apparatus is placed as close to the supply as possible and contains the sense unit 200, a control unit 310 and a plurality of reactive units 315. The sense unit is coupled to a power line 205 and contains a first sense circuit 220 responsible for the indication of a phase difference between a voltage and a current associated with the power line 205 and a further sense circuit 225 responsible for the indication of a power magnitude based on the voltage and the current associated with the power line 205. The first sense circuitry 220 and the further sense circuitry 225 both contain a first feedback element 239, 240 that is non-intrusively and inductively coupled to the power line 205 for providing a first feedback voltage that is representative of the phase of the voltage associated with the power line 205. Aptly the first feedback element 239, 240 comprises an inductor. Aptly the first feedback element and the power line can be provided by a conventional transformer in which the power line 205 acts as a primary coil and an inductor in the first feedback element acts as a secondary coil. Aptly this is a toroidal transformer but may also be an in-line transformer or any other suitable transformer orientation.

The first and further sense circuitry both also contain a further feedback element 239, 240 that is intrusively and capacitively coupled to the power line 205 for providing a further feedback voltage representative of the phase of the current associated with the power line 205. Aptly the further feedback element comprises two capacitors that are connected in series. The further feedback element allows a flow of AC current via charging and discharging cycles of the series capacitors. The first sense circuit and the second sense circuit both further include a diode direction stage, a filter stage and a trimmer stage. The diode direction stage comprises two diodes oriented in such a way as to determine the direction of, and to prevent the backflow of, current through the filter stage and the trimmer stage. The filter stage is a PI filter for the attenuation of high frequency noise comprising two serially connected class-Y capacitors, each pair of serially connected capacitors further connected in parallel, and two resistors connected in series with the diode direction stage. Other filtering arrangements could of course be utilised. The trimmer stage allows for an output voltage that is representative of a directionally define and filtered current responsive to the first feedback voltage and the further feedback voltage for indicating a characteristic associated with a power factor of electrical power delivered through the power line at a suitably scaled magnitude for input into the control unit 210.

The control unit 310 receives an input setpoint and is connected to a variable capacitor 320 and a variable inductor 330. The reactance of the variable capacitor 320 and the variable inductor 330 is automatically tuned by closed loop feedback control based on the voltage output of the first sense circuit and the second sense circuit to compensate for inductive or capacitive loads in the electrical system and to achieve a desired power factor of power delivery through the power line 205. In the embodiment shown, the control unit 310 allows for a user specified power factor target or load setpoint via a user interface such as a computer (not shown) which is maintained by tuning the variable capacitor 320 and the variable inductor 330. Optionally the target power factor or load setpoint can be specified via any other means of communicating information representative of a power factor or load setpoint to the control unit 310. Optionally the target power factor can be a predetermined or pre-set value in the control unit 310.

Certain embodiments of the present invention relate to the control of power factor in a subsea environment. Certain embodiments of the present invention are useful for power delivery industries. Certain embodiments of the present invention are useful for 50 Hz and 60 Hz systems as well as RF Antenna transmitter technology in higher frequency bands. Certain embodiments of the present invention provide circuitry that is adaptable for power factor delivery in a wide range of AC power delivery with a range of frequencies.

Throughout the description and claims of this specification, the words "comprise" and "contain" and variations of them mean "including but not limited to" and they are not intended to (and do not) exclude other moieties, additives, components, integers or steps. Throughout the description and claims of this specification, the singular encompasses the plural unless the context otherwise requires. In particular, where the indefinite article is used, the specification is to be understood as contemplating plurality as well as singularity, unless the context requires otherwise.

Features, integers, characteristics or groups described in conjunction with a particular aspect, embodiment or example of the invention are to be understood to be applicable to any other aspect, embodiment or example described herein unless incompatible therewith. All of the features disclosed in this specification (including any accompanying claims, abstract and drawings), and/or all of the steps of any method or process so disclosed, may be combined in any combination, except combinations where at least some of the features and/or steps are mutually exclusive. The invention is not restricted to any details of any foregoing embodiments. The invention extends to any novel one, or novel combination, of the features disclosed in this specification (including any accompanying claims, abstract and drawings), or to any novel one, or any novel combination, of the steps of any method or process so disclosed. However, the invention is defined by the features of the independent claims. Preferred embodiments are defined in the dependent claims.

## Claims

1. Apparatus for indicating a characteristic associated with a power factor for a power line (205), the apparatus comprising:
at least one first feedback element (229, 230) arranged to couple to a power line (205) that delivers electrical power from an Alternating Current (AC) source to a load and arranged to provide a first feedback voltage that represents a voltage provided by the power line (205); and
at least one further feedback element (239, 240) arranged to couple to the power line (205) and arranged to provide a further feedback voltage that represents a current provided by the power line (205); and
at least one impedance element (265);
**characterized by** the at least one impedance element (265), having an electrical impedance, wherein a first potential difference across the impedance element (265) that is responsive to a potential difference between the first feedback voltage that represents a voltage provided by the power line (205) and the further feedback voltage that represents a current provided by the power line (205), indicates a characteristic associated with a power factor for the power line (205).

2. The apparatus as claimed in claim 1, further comprising:
the first feedback element (229, 230) comprises at least one inductive element inductively coupled to the power line (205); and
the further feedback element (239, 240) comprises at least one capacitive element (241 - 244) connected to the power line (205).

3. The apparatus as claimed in claim 2, further comprising:
the at least one capacitive element comprises a series of capacitors (241 - 244) connected at a first end of the series to the power line (205) and at a remaining end of the series to a remaining connection node.

4. The apparatus as claimed in claim 1 or claim 2, further comprising:
a trimmer stage (257, 260) responsive to the first potential difference for selectively trimming and providing an output voltage within a desired voltage range.

5. The apparatus as claimed in any preceding claim, further comprising:
a PI filter stage (250, 251), responsive to the first potential difference, comprising at least a pair of serially connected capacitors and at least a first and further resistor for supressing noise.

6. The apparatus as claimed in any preceding claim, further comprising:
a diode direction stage (245, 246) comprising a first and a further diode.

7. The apparatus as claimed in claim 1 wherein the characteristic is a first reference voltage indicative of a phase relationship between a current and a voltage associated with the power line (205).

8. The apparatus as claimed in claim 7, further comprising:
a resistive element (269) connected in a first series arrangement (265) with the impedance element (267) wherein a first end of the first series arrangement is 180° out of phase with a remaining end of the series arrangement.

9. The apparatus as claimed in claim 8, further comprising:
a centre point (270) between the resistive element (269) and said impedance element (267) in the series arrangement (265) is connected to a remaining connection node at a remaining end of a series of capacitors (241 - 244) connected at a first end thereof to the power line (205).

10. The apparatus as claimed in claim 1 wherein the characteristic is a further reference voltage indicative of a real power delivered via the power line (205).

11. The apparatus as claimed in claim 10, further comprising:
a further resistive element connected in a further series arrangement with said impedance element wherein a first end of the further series arrangement is connected to a remaining connection node at a remaining end of a series of capacitors (241 - 244) connected, at a first end of the series of capacitors, to the power line (205).

12. A subsea system, comprising:
a top-side facility comprising an Alternating Current (AC) power source (120);
a power line (110) coupled to the AC power source (120) for power supply to a subsea location;
at least one subsea device (140, 150, 160, 170) at the subsea location coupled to the power line (110); and
the apparatus as claimed in any preceding claim coupled to the power line (110) for indicating a power factor of power associated with the power line.

13. Apparatus for determining a power factor for a power line, the apparatus comprising:
the apparatus as claimed in any of claims 1 to 11;
a control unit (210, 310) that provides at least one control signal responsive to said a characteristic; and
at least one capacitive element (280, 320) and/or at least one inductive element (285, 330) selectively connectable to the power line (205) responsive to the control signal.

14. The apparatus as claimed in claim 13, further comprising:
the control unit is a relay-based control system;
said at least one capacitive element (280) comprises a plurality of capacitive elements each with a predetermined capacitance and selectively connectable to the power line (205); and
said at least one inductive element (285) comprises a plurality of inductor elements each with a predetermined inductance and selectively connectable to the power line (205).

15. The apparatus as claimed in claim 13, further comprising:
the control unit is a closed loop control system with a selectable set point;
the at least one capacitive element (320) is a variable capacitor having a capacitance that is variable and controllable responsive to the control signal; and
the at least one inductive element (330) is a variable inductor having an inductance that is variable and controllable responsive to the control signal.

16. A method for indicating at least one characteristic associated with a power factor for a power line (205), comprising the steps of:
providing at least one first feedback voltage that represents a voltage provided by a power line (205) that delivers electrical power from an Alternating Current (AC) source (120) to a load;
providing at least one further feedback voltage that represents a current provided by the power line (205);
the method is further comprising:
providing at least one first potential difference across at least one impedance element, that has an electrical impedance, responsive to a potential difference between the first feedback voltage that represents a voltage provided by the power line (205) and the further feedback voltage that represents a current provided by the power line (205), whereby the first potential difference is indicative of at least one characteristic associated with a power factor for the power line (205).

17. The method as claimed in claim 16, further comprising:
providing at least one first reference voltage indicative of a phase relationship between a current and a voltage associated with the power line (205); and
simultaneously providing a further reference voltage indicative of a real power delivered by the power line (205).

18. The method as claimed in claim 16 or claim 17, further comprising:
providing the first feedback voltage via at least one inductive element (229, 230) inductively coupled to the power line (205); and
providing the further feedback voltage via at least one capacitive element (239, 240) connected to the power line (205) whereby optionally the capacitive element comprises a series of capacitors (241 - 244) connected, at a first end of the series, to the power line (205) and at a remaining end of the series to a remining connection node.

19. The method as claimed in claim 17, further comprising:
via a diode direction stage (245, 246), providing a diode stage output voltage signal;
via a PI filter stage (250, 251), providing a filtered output voltage signal by filtering noise on the diode stage output voltage signal; and
via a trimmer stage (257, 260), providing an output voltage within a desired voltage range responsive to the filtered output voltage signal.

20. The method as claimed in claim 17, further comprising:
providing a control signal responsive to the first reference voltage and/or the further reference voltage that selectively connects at least one capacitive element (280, 320) and/or at least one inductive element (285, 330) to the power line (205).

## Patentansprüche

1. Vorrichtung zum Angeben einer Charakteristik, die einem Leistungsfaktor für eine Leistungsleitung (205) zugeordnet ist, die Vorrichtung umfassend:
mindestens ein erstes Rückkopplungselement (229, 230), das angeordnet ist, um mit einer Leistungsleitung (205) zu koppeln, die elektrische Leistung von einer Wechselstromquelle (AC-Quelle) an einen Verbraucher liefert, und angeordnet ist, um eine erste Rückkopplungsspannung bereitzustellen, die eine durch die Leistungsleitung (205) bereitgestellte Spannung darstellt; und
mindestens ein weiteres Rückkopplungselement (239, 240), das angeordnet ist, um mit der Leistungsleitung (205) zu koppeln, und angeordnet ist, um eine weitere Rückkopplungsspannung bereitzustellen, die einen durch die Leistungsleitung (205) bereitgestellten Strom darstellt; und
mindestens ein Impedanzelement (265);
**gekennzeichnet durch** das mindestens eine Impedanzelement (265), das eine elektrische Impedanz aufweist, wobei eine erste Potentialdifferenz an dem Impedanzelement (265), die auf eine Potentialdifferenz zwischen der ersten Rückkopplungsspannung, die eine durch die Leistungsleitung (205) bereitgestellte Spannung darstellt, und der weiteren Rückkopplungsspannung, die einen durch die Leistungsleitung (205) bereitgestellten Strom darstellt, reagiert, eine Charakteristik angibt, die einem Leistungsfaktor für die Leistungsleitung (205) zugeordnet ist.

2. Vorrichtung nach Anspruch 1, ferner umfassend:
das erste Rückkopplungselement (229, 230), das mindestens ein induktives Element, das mit der Leistungsleitung (205) induktiv gekoppelt ist, umfasst; und
das weitere Rückkopplungselement (239, 240), das mindestens ein mit der Leistungsleitung (205) verbundenes kapazitives Element (241 - 244) umfasst.

3. Vorrichtung nach Anspruch 2, ferner umfassend:
das mindestens eine kapazitive Element, das eine Reihe von Kondensatoren (241 -244) umfasst, die an einem ersten Ende der Reihe mit der Leistungsleitung (205) und an einem verbleibenden Ende der Reihe mit einem verbleibenden Verbindungsknoten verbunden sind.

4. Vorrichtung nach Anspruch 1 oder Anspruch 2, ferner umfassend:
eine Trimmerstufe (257, 260), die auf die erste Potentialdifferenz reagiert, zum selektiven Trimmen und Bereitstellen einer Ausgangsspannung innerhalb eines gewünschten Spannungsbereichs.

5. Vorrichtung nach einem der vorstehenden Ansprüche, ferner umfassend:
eine PI-Filterstufe (250, 251), die auf die erste Potentialdifferenz reagiert, umfassend mindestens ein Paar von in Reihe geschalteten Kondensatoren und mindestens einen ersten und einen weiteren Widerstand zum Unterdrücken von Rauschen.

6. Vorrichtung nach einem der vorstehenden Ansprüche, ferner umfassend:
eine Diodenrichtungsstufe (245, 246), umfassend eine erste und eine weitere Diode.

7. Vorrichtung nach Anspruch 1, wobei die Charakteristik eine erste Referenzspannung ist, die eine Phasenbeziehung zwischen einem Strom und einer Spannung angibt, die der Leistungsleitung (205) zugeordnet sind.

8. Vorrichtung nach Anspruch 7, ferner umfassend:
ein Widerstandselement (269), das in einer ersten Reihenanordnung (265) mit dem Impedanzelement (267) verbunden ist, wobei ein erstes Ende der ersten Reihenanordnung um 180° phasenverschoben zu einem verbleibenden Ende der Reihenanordnung ist.

9. Vorrichtung nach Anspruch 8, ferner umfassend:
einen Mittelpunkt (270) zwischen dem Widerstandselement (269) und dem Impedanzelement (267) in der Reihenanordnung (265), der mit einem verbleibenden Verbindungsknoten an einem verbleibenden Ende einer Reihe von Kondensatoren (241 - 244) verbunden ist, die an einem ersten Ende davon mit der Leistungsleitung (205) verbunden sind.

10. Vorrichtung nach Anspruch 1, wobei die Charakteristik eine weitere Referenzspannung ist, die eine Wirkleistung angibt, die über die Leistungsleitung (205) geliefert wird.

11. Vorrichtung nach Anspruch 10, ferner umfassend:
ein weiteres Widerstandselement, das in einer weiteren Reihenanordnung mit dem Impedanzelement verbunden ist, wobei ein erstes Ende der weiteren Reihenanordnung mit einem verbleibenden Verbindungsknoten an einem verbleibenden Ende einer Reihe von Kondensatoren (241 - 244) verbunden ist, die an einem ersten Ende der Reihe von Kondensatoren mit der Leistungsleitung (205) verbunden sind.

12. Unterwassersystem, umfassend:
eine Einrichtung auf der Oberseite, umfassend eine Wechselstromleistungsquelle (AC-Leistungsquelle) (120);
eine Leistungsleitung (110), die mit der AC-Leistungsquelle (120) gekoppelt ist, für eine Leistungsversorgung eines Unterwasserstandorts;
mindestens eine Unterwasservorrichtung (140, 150, 160, 170) an dem Unterwasserstandort, die mit der Leistungsleitung (110) gekoppelt ist; und
die Vorrichtung nach einem der vorstehenden Ansprüche, die mit der Leistungsleitung (110) gekoppelt ist zum Angeben eines Leistungsfaktors der Leistung, der der Leistungsleitung zugeordnet ist.

13. Vorrichtung zum Bestimmen eines Leistungsfaktors für eine Leistungsleitung, die Vorrichtung umfassend:
die Vorrichtung nach einem der Ansprüche 1 bis 11;
eine Steuereinheit (210, 310), die mindestens ein Steuersignal bereitstellt, das auf die eine Charakteristik reagiert; und
mindestens ein kapazitives Element (280, 320) und/oder mindestens ein induktives Element (285, 330), das mit der Leistungsleitung (205) selektiv verbindbar ist, das auf das Steuersignal reagiert.

14. Vorrichtung nach Anspruch 13, ferner umfassend:
die Steuereinheit, die ein relaisbasiertes Steuersystem ist;
das mindestens eine kapazitive Element (280), das eine Vielzahl von kapazitiven Elementen umfasst, jedes mit einer vorbestimmten Kapazität und mit der Leistungsleitung (205) selektiv verbindbar; und
das mindestens eine induktive Element (285), das eine Vielzahl von induktiven Elementen umfasst, jedes mit einer vorbestimmten Induktivität und mit der Leistungsleitung (205) selektiv verbindbar.

15. Vorrichtung nach Anspruch 13, ferner umfassend:
die Steuereinheit, die ein Steuersystem mit geschlossenem Regelkreis mit einem auswählbaren Sollwert ist;
das mindestens eine kapazitive Element (320), das ein variabler Kondensator ist, der eine Kapazität aufweist, die variabel ist und auf das Steuersignal steuerbar reagiert; und
das mindestens eine induktive Element (330), das ein variabler Induktor ist, der eine Induktivität aufweist, die variabel ist und auf das Steuersignal steuerbar reagiert.

16. Verfahren zum Angeben mindestens einer Charakteristik, die einem Leistungsfaktor für eine Leistungsleitung (205) zugeordnet ist, umfassend die Schritte:
Bereitstellen mindestens einer ersten Rückkopplungsspannung, die eine Spannung darstellt, die durch eine Leistungsleitung (205) bereitgestellt wird, die elektrische Leistung von einer Wechselstromquelle (AC-Quelle) (120) an einen Verbraucher liefert;
Bereitstellen mindestens einer weiteren Rückkopplungsspannung, die einen durch die Leistungsleitung (205) bereitgestellten Strom darstellt;
das Verfahren ferner umfassend:
Bereitstellen mindestens einer ersten Potentialdifferenz an mindestens einem Impedanzelement, das eine elektrische Impedanz aufweist, die auf eine Potentialdifferenz zwischen der ersten Rückkopplungsspannung, die eine durch die Leistungsleitung (205) bereitgestellte Spannung darstellt, und der weiteren Rückkopplungsspannung, die einen durch die Leistungsleitung (205) bereitgestellten Strom darstellt, reagiert, wodurch die erste Potentialdifferenz mindestens eine Charakteristik angibt, die einem Leistungsfaktor für die Leistungsleitung (205) zugeordnet ist.

17. Verfahren nach Anspruch 16, ferner umfassend:
Bereitstellen mindestens einer ersten Referenzspannung, die eine Phasenbeziehung zwischen einem Strom und einer Spannung angibt, die der Leistungsleitung (205) zugeordnet sind; und
gleichzeitiges Bereitstellen einer weiteren Referenzspannung, die eine Wirkleistung angibt, die durch die Leistungsleitung (205) geliefert wird.

18. Verfahren nach Anspruch 16 oder 17, ferner umfassend:
Bereitstellen der ersten Rückkopplungsspannung über mindestens ein induktives Element (229, 230), das mit der Leistungsleitung (205) induktiv gekoppelt ist; und
Bereitstellen der weiteren Rückkopplungsspannung über mindestens ein kapazitives Element (239, 240), das mit der Leistungsleitung (205) verbunden ist, wodurch optional das kapazitive Element eine Reihe von Kondensatoren (241 - 244) umfasst, die an einem ersten Ende der Reihe mit der Leistungsleitung (205) und an einem verbleibenden Ende der Reihe mit einem verbleibenden Verbindungsknoten verbunden sind.

19. Verfahren nach Anspruch 17, ferner umfassend:
über eine Diodenrichtungsstufe (245, 246), Bereitstellen eines Ausgangsspannungssignals einer Diodenstufe;
über eine PI-Filterstufe (250, 251), Bereitstellen eines gefilterten Ausgangsspannungssignals durch Filtern von Rauschen des Ausgangsspannungssignals der Diodenstufe; und
über eine Trimmerstufe (257, 260), Bereitstellen einer Ausgangsspannung innerhalb eines gewünschten Spannungsbereichs, die auf das gefilterte Ausgangsspannungssignal reagiert.

20. Verfahren nach Anspruch 17, ferner umfassend:
Bereitstellen eines Steuersignals, das auf die erste Referenzspannung und/oder die weitere Referenzspannung reagiert, das mindestens ein kapazitives Element (280, 320) und/oder mindestens ein induktives Element (285, 330) mit der Leistungsleitung (205) selektiv verbindet.

## Revendications

1. Appareil permettant d'indiquer une caractéristique associée à un facteur de puissance pour une ligne électrique (205), l'appareil comprenant :
au moins un premier élément de rétroaction (229, 230) agencé pour se coupler à une ligne électrique (205) qui délivre une puissance électrique provenant d'une source de courant alternatif (CA) à une charge et agencée pour fournir une première tension de rétroaction qui représente une tension fournie par la ligne électrique (205) ; et
au moins un élément de rétroaction supplémentaire (239, 240) agencé pour se coupler à la ligne électrique (205) et agencé pour fournir une tension de rétroaction supplémentaire qui représente un courant fourni par la ligne électrique (205) ; et
au moins un élément d'impédance (265) ;
**caractérisé en ce que** l'au moins un élément d'impédance (265), ayant une impédance électrique, dans lequel une première différence de potentiel à travers l'élément d'impédance (265) qui est sensible à une différence de potentiel entre la première tension de rétroaction qui représente une tension fournie par la ligne électrique (205) et la tension de rétroaction supplémentaire qui représente un courant fourni par la ligne électrique (205), indique une caractéristique associée à un facteur de puissance pour la ligne électrique (205).

2. Appareil selon la revendication 1, comprenant en outre :
le premier élément de rétroaction (229, 230) comprend au moins un élément inductif couplé par induction à la ligne électrique (205) ; et
l'élément de rétroaction supplémentaire (239, 240) comprend au moins un élément capacitif (241 - 244) connecté à la ligne électrique (205).

3. Appareil selon la revendication 2, comprenant en outre :
l'au moins un élément capacitif comprend une série de condensateurs (241 - 244) connectée au niveau d'une première extrémité de la série à la ligne électrique (205) et au niveau d'une extrémité restante de la série à un noeud de connexion restant.

4. Appareil selon la revendication 1 ou la revendication 2, comprenant en outre :
un étage de condensateur d'ajustage d'appoint (257, 260) en réponse à la première différence de potentiel pour un ajustage d'appoint et une fourniture sélective d'une tension de sortie dans une plage de tension souhaitée.

5. Appareil selon l'une quelconque revendication précédente, comprenant en outre :
un étage de filtre en PI (250, 251), en réponse à la première différence de potentiel, comprenant au moins une paire de condensateurs connectés en série et au moins une première résistance et une résistance supplémentaire pour supprimer le bruit.

6. Appareil selon l'une quelconque revendication précédente, comprenant en outre :
un étage de direction de diode (245, 246) comprenant une première et une diode supplémentaire.

7. Appareil selon la revendication 1, dans lequel la caractéristique est une première tension de référence indiquant une relation de phase entre un courant et une tension associée à la ligne électrique (205).

8. Appareil selon la revendication 7, comprenant en outre :
un élément résistif (269) connecté dans un premier agencement en série (265) avec l'élément d'impédance (267) dans lequel une première extrémité du premier agencement en série est déphasée à 180° avec une extrémité restante de l'agencement en série.

9. Appareil selon la revendication 8, comprenant en outre :
un point central (270) entre l'élément résistif (269) et ledit élément d'impédance (267) dans l'agencement en série (265) est connecté à un noeud de connexion restant au niveau d'une extrémité restante d'une série de condensateurs (241 - 244) connectée au niveau d'une première extrémité de celui-ci à la ligne électrique (205).

10. Appareil selon la revendication 1, dans lequel la caractéristique est une tension de référence supplémentaire indiquant une puissance réelle délivrée par l'intermédiaire de la ligne électrique (205).

11. Appareil selon la revendication 10, comprenant en outre :
un élément résistif supplémentaire connecté dans un agencement supplémentaire en série avec ledit élément d'impédance, dans lequel une première extrémité de l'agencement en série supplémentaire est connectée à un noeud de connexion restant au niveau d'une extrémité restante d'une série de condensateurs (241 - 244) connecté, au niveau d'une première extrémité de la série de condensateurs, à la ligne électrique (205).

12. Système sous-marin, comprenant :
une installation côté supérieur comprenant une source d'alimentation en courant alternatif (CA) (120) ;
une ligne électrique (110) couplée à la source d'alimentation CA (120) pour l'alimentation électrique d'un emplacement sous-marin ;
au moins un dispositif sous-marin (140, 150, 160, 170) au niveau de l'emplacement sous-marin couplé à la ligne électrique (110) ; et
l'appareil selon l'une quelconque revendication précédente couplé à la ligne électrique (110) pour indiquer un facteur de puissance de puissance associé à la ligne électrique.

13. Appareil de détermination d'un facteur de puissance pour une ligne électrique, l'appareil comprenant :
l'appareil selon l'une quelconque des revendications 1 à 11 ;
une unité de commande (210, 310) qui fournit au moins un signal de commande en réponse à ladite une caractéristique ; et
au moins un élément capacitif (280, 320) et/ou au moins un élément inductif (285, 330) pouvant être connecté sélectivement à la ligne électrique (205) en réponse au signal de commande.

14. Appareil selon la revendication 13, comprenant en outre :
l'unité de commande est un système de commande à relais ;
ledit au moins un élément capacitif (280) comprend une pluralité d'éléments capacitifs chacun avec une capacité prédéterminée et pouvant être connecté sélectivement à la ligne électrique (205) ; et
l'au moins un élément inductif (285) comprend une pluralité d'éléments d'inductance chacun avec une inductance prédéterminée et pouvant être connecté sélectivement à la ligne électrique (205).

15. Appareil selon la revendication 13, comprenant en outre :
l'unité de commande est un système de commande en boucle fermée avec un point de consigne sélectionnable ;
l'au moins un élément capacitif (320) est un condensateur variable ayant une capacité qui est variable et peut être commandée en réponse au signal de commande ; et
l'au moins un élément inductif (330) est un inducteur variable ayant une inductance qui est variable et peut être commandée en réponse au signal de commande.

16. Procédé permettant d'indiquer au moins une caractéristique associée à un facteur de puissance pour une ligne électrique (205), comprenant les étapes consistant à :
fournir au moins une première tension de rétroaction qui représente une tension fournie par une ligne électrique (205) qui délivre de l'énergie électrique à partir d'une source de courant alternatif (CA) (120) à une charge ;
la fourniture d'au moins une tension de rétroaction supplémentaire qui représente un courant fourni par la ligne électrique (205) ;
le procédé comprenant en outre :
la fourniture d'au moins une première différence de potentiel à travers au moins un élément d'impédance, qui a une impédance électrique, en réponse à une différence de potentiel entre la première tension de rétroaction qui représente une tension fournie par la ligne électrique (205) et la tension de rétroaction supplémentaire qui représente un courant fourni par la ligne électrique (205), moyennant quoi la première différence de potentiel indique au moins une caractéristique associée à un facteur de puissance pour la ligne électrique (205).

17. Procédé selon la revendication 16, comprenant en outre :
la fourniture d'au moins une première tension de référence indiquant une relation de phase entre un courant et une tension associée à la ligne électrique (205) ; et
simultanément la fourniture d'une tension de référence supplémentaire indiquant une puissance réelle délivrée par la ligne électrique (205).

18. Procédé selon la revendication 16 ou la revendication 17, comprenant en outre :
la fourniture de la première tension de rétroaction par l'intermédiaire d'au moins un élément inductif (229, 230) couplé par induction à la ligne électrique (205) ; et
la fourniture de la tension de rétroaction supplémentaire par l'intermédiaire d'au moins un élément capacitif (239, 240) connecté à la ligne électrique (205), moyennant quoi facultativement l'élément capacitif comprend une série de condensateurs (241 - 244) connectée, au niveau d'une première extrémité de la série, à la ligne électrique (205) et au niveau d'une extrémité restante de la série à un noeud de connexion restant.

19. Procédé selon la revendication 17, comprenant en outre :
par l'intermédiaire d'un étage de direction de diode (245, 246), la fourniture d'un signal de tension de sortie d'étage de diode ;
par l'intermédiaire d'un étage de filtre en PI (250, 251), la fourniture d'un signal de tension de sortie filtré par filtrage du bruit sur le signal de tension de sortie d'étage de diode ; et
par l'intermédiaire d'un étage de condensateur d'ajustage d'appoint (257, 260), la fourniture d'une tension de sortie au sein d'une plage de tension souhaitée en réponse au signal de tension de sortie filtré.

20. Procédé selon la revendication 17, comprenant en outre :
la fourniture d'un signal de commande en réponse à la première tension de référence et/ou à la tension de référence supplémentaire qui connecte sélectivement au moins un élément capacitif (280, 320) et/ou au moins un élément inductif (285, 330) à la ligne électrique (205).
